# EUROPEAN PATENT SPECIFICATION

(11) **EP 1 474 294 B1**
(45) Date of publication and mention of the grant of the patent: **25.10.2006**
(21) Application number: 03701168.1
(22) Date of filing: 10.01.2003
(51) Int. Cl.: B41F 15/14, B41F 15/08, B41F 15/00, B41M 1/12, B41C 1/14, B41M 7/00

(54) **METHOD OF SILK SCREEN PRINTING**
SIEBDRUCKVERFAHREN
PROCEDE DE SERIGRAPHIE

(30) Priority: 11.01.2002 KR 2002001600
(43) Date of publication of application: 10.11.2004
(73) Proprietor: Choi, Yong-Seok, Hwaseong-gun, 445-974 Gyeonggi-do (KR)
(72) Inventor: Choi, Yong-Seok, Hwaseong-gun, 445-974 Gyeonggi-do (KR)
(74) Representative: Lamb, Martin John Carstairs
(86) International application number: PCT/KR2003/000046
(87) International publication number: WO 2003/057486

(56) References cited:
- US-A- 3 198 109
- US-A- 5 388 509
- US-A- 5 390 595
- US-A- 5 609 967
- US-A- 5 806 424

## Description

### TECHNICAL FIELD

The present invention pertains, in general, to methods of silk screen printing. More specifically, the present invention discloses a method of preparing a printed object with a surface which is uneven and has excellent tactile properties without gathering hand prints.

### PRIOR ART

Typically, a printing process has been mainly used for preparation of calendars haying photographs. However, photographs printed through such a printing process suffer from smooth surface, unpleasant tactile sensation and gathering of fingerprints or hand prints.

Therefore, there is required for a method for producing printed objects making a favorable impression on a viewer, and having good tactile properties.

### DISCLOSURE OF THE INVENTION

Accordingly, it is an object of the present invention to solve the problems encountered in the prior art and to provide a method of preparing a printed object having an uneven surface and excellent tactile properties without gathering hand prints.

It is another object of the present invention to provide a method of preparing a printed object of high quality.

### BRIEF DESCRIPTION OF THE DRAWINGS

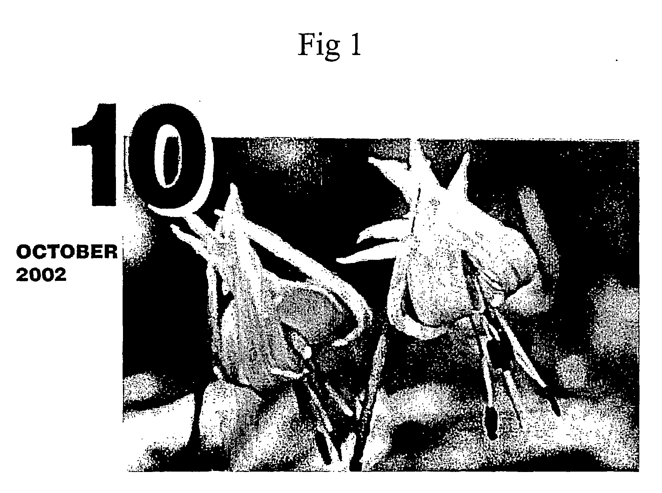

Fig. 1 is a photograph printed by conventional techniques; and
Fig. 2 is a photograph printed by the method of the present invention.

### BEST MODES FOR CARRYING OUT THE INVENTION

Leading to the present invention, the intensive and thorough research on printing methods carried out by the present inventors aiming to achieve the above objects, led to the development of a method of preparing printed objects which are natural and of high quality by changing the number of lines and dot percentage of a film placed on a screen and mesh counts of the screen. Such a method is called 'photo technique'.

In the silk screen printing method of the present invention, a diagonal screen made of a screen fabric having a mesh count of 200-300 is coated with a light sensitive emulsion and dried, and a film of 40-60 lines and 60-70 dot percentage is placed thereon. Then, such a diagonal screen is exposed to ultra-violet light for 1-2 min, and the screen areas which have not been exposed to the light are washed out, followed by conducting a screen printing process and an ink curing process.

Generally, film lines range from 40 to 175. As for the film useful in the photo technique of the present invention, a film of 40-60 lines is used. The lower the number of lines, the rougher the surface. Meanwhile, the higher the number of lines, the softer the surface. In order to form an uneven surface, a film of 60 lines or lower is preferably used. Of films of 175 lines and 10-100 dot percentage or 40 lines and 10-100 dot percentage, it is preferred that a film of 40-60 lines and 60-70 dot percentage is used.

As for the screen, a screen fabric having a mesh count of 60-420 is generally used, but in the present invention, a screen having a mesh count of 200-300 is used. Particularly, a diagonal screen is used for detailed line work in the photo technique.

Most preferably, when printing for providing soft feeling is performed, a film of 60 lines and 60 dot percentage is selected and a diagonal screen having a mesh count of 250 is used. On the other hand, a printing process for providing rough feeling requires a film of 40 lines and 60 dot percentage and a diagonal screen having 250 mesh count.

Upon printing, a scale of a coater is kept constant and a scale of a squeegee is set to 0 (zero). A distance between the coater and the squeegee is regulated in the range of 5.0-5.4cm. A squeegee angle may be adjusted in the range of 15 to 45° depending on the scale of the squeegee. When the scale of the squeegee is set to 15mm, a printing process is carried out at a squeegee angle of 45°.

An ink curing process is carried out by use of a UV lamp, in which the lamp is exemplified by a mercury lamp or a metal lamp having intensity of illumination of 1500-1800 lux.

A better understanding of the present invention may be obtained in light of the following examples which are set forth to illustrate, but are not to be construed to limit the present invention.

### EXAMPLE

100 x 110cm of a diagonal screen having a mesh count of 250-300 was coated once at front and back faces thereof with a light sensitive emulsion having the trade name ULANO 569, and dried for 5 min using a heat dryer. The dried back face of the screen was further coated three times with the emulsion, and the front face of the screen was further coated twice, after which the coated faces were dried for 5 min by use of a heat dryer. The screen was placed onto a process camera, on which a film (40 lines, 60 dot percentage) was superimposed. Thereafter, the screen having the film placed thereon was exposed to ultra-violet light for 90 s, and the screen areas which had not been exposed to the light were washed out with water.

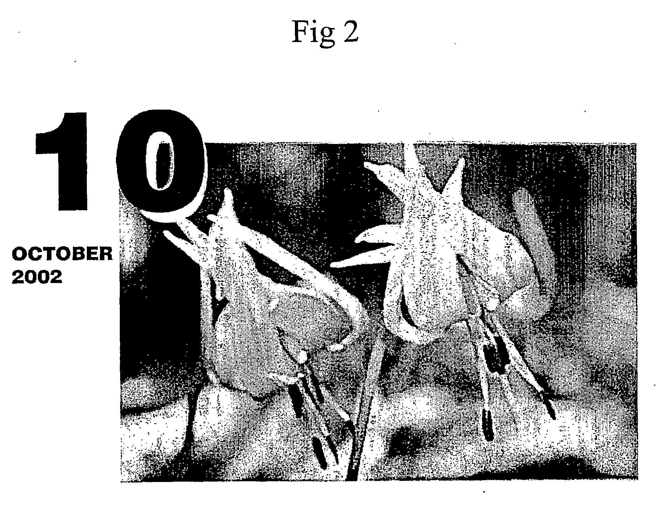

Then, a printing process was performed using etching S ink available from Burim Chemical Co. Ltd. (Korea) and a Sakurai automatic printing machine. The distance between the coater and the squeegee was 5.2cm, and the squeegee angle was controlled to 45°. The printed object is shown in Fig. 2.

### INDUSTRIAL APPLICABILITY

As described above, objects printed by the printing method of the present invention make a favorable impression on a viewer due to formation of a surface which is uneven and is not smooth while not gathering hand prints.

The printing method of the present invention is preferably applied for preparation of printed objects, such as calendars with photographs, as well as all other printed objects and other photographs.

The present invention has been described in an illustrative manner, and it is to be understood that the terminology used is intended to be in the nature of description rather than of limitation.

## Claims

1. A method of silk screen printing comprising the steps of: coating a diagonal screen made of a screen fabric having a mesh count of 200-300 with a light sensitive emulsion, followed by drying the coated screen; placing a film of 40-60 lines and 60-70 dot percentage on the screen; exposing the screen having the film placed thereon to ultra-violet light for 1-2 min; washing out the screen areas which have not been exposed to the light; and performing screen printing and ink curing.

2. The method as defmed in claim 1, wherein the film has 40 lines and 60 dot percentage.

3. The method as defined in claim 1, wherein the film has 60 lines and 60 dot percentage.

4. The method as defined in claim 1, wherein a distance between a coater and a squeegee is 5.2cm.

5. The method as defined in claim 1, wherein a squeegee angle is 45°.

## Patentansprüche

1. Siebdruckverfahren, das die folgenden Schritte aufweist: Beschichten eines Diagonalsiebes aus einem Siebstoff mit einer Maschenzahl von 200 bis 300 mit einer lichtempfindlichen Emulsion, gefolgt vom Trocknen des beschichteten Siebes; Anordnen eines Filmes mit 40 bis 60 Linien und einem Prozentanteil von 60 bis 70 Punkten auf dem Sieb; Aussetzen des Siebes mit dem darauf angeordneten Film einem ultravioletten Licht über 1-2 min.; Auswaschen der Siebbereiche, die nicht dem Licht ausgesetzt wurden; und Durchführen des Siebdruckens und Aushärtens der Druckfarbe.

2. Verfahren nach Anspruch 1, bei dem der Film 40 Linien und einen Prozentanteil von 60 Punkten aufweist.

3. Verfahren nach Anspruch 1, bei dem der Film 60 Linien und einen Prozentanteil von 60 Punkten aufweist.

4. Verfahren nach Anspruch 1, bei dem ein Abstand zwischen einer Beschichtungsanlage und einer Siebdruckrakel 5,2 cm beträgt.

5. Verfahren nach Anspruch 1, bei dem ein Siebdruckrakelwinkel 45° beträgt.

## Revendications

1. Procédé de sérigraphie, comprenant les étapes ci-dessous: revêtement d'un écran diagonal composé d'un tissu pour pochoir ayant un nombre de fils compris entre 200 et 300 avec une émulsion sensible à la lumière, suivi par le séchage de l'écran revêtu; positionnement d'un film de 40 à 60 lignes et d'un pourcentage de points de 60 à 70 sur l'écran; exposition de l'écran comportant le film qui y est positionné à la lumière ultraviolette pendant 1 à 2 minutes; lavage des zones de l'écran n'ayant pas été exposées à la lumière; et exécution d'une sérigraphie et d'un séchage de l'encre.

2. Procédé selon la revendication 1, dans lequel le film comporte 40 lignes et un pourcentage de points de 60.

3. Procédé selon la revendication 1, dans lequel le film comporte 60 lignes et un pourcentage de points de 60.

4. Procédé selon la revendication 1, dans lequel une distance entre un dispositif à enduire et une raclette correspond à 5,2 cm.

5. Procédé selon la revendication 1, dans lequel un angle de raclette correspond à 45°.
